# EUROPÄISCHE PATENTSCHRIFT

(11) **EP 3 262 671 B1**
(45) Veröffentlichungstag und Bekanntmachung des Hinweises auf die Patenterteilung: **05.08.2020**
(21) Anmeldenummer: 16716820.2
(22) Anmeldetag: 24.02.2016
(51) Int. Cl.: H01J 35/32, H05F 3/06

(54) **RÖNTGENQUELLE ZUR IONISIERUNG VON GASEN**
X-RAY SOURCE FOR IONISING OF GASES
SOURCE DE RAYONS X POUR L'IONISATION DE GAZ

(30) Priorität: 24.02.2015 DE 102015102612
(43) Veröffentlichungstag der Anmeldung: 03.01.2018
(73) Patentinhaber: Estion Technologies GmbH, 64347 Griesheim (DE)
(72) Erfinder: SEBALD, Thomas, 64289 Darmstadt (DE)
(74) Vertreter: Lippert Stachow Patentanwälte Rechtsanwälte Partnerschaft mbB
(86) Internationale Anmeldenummer: PCT/DE2016/100081
(87) Internationale Veröffentlichungsnummer: WO 2016/134701

(56) Entgegenhaltungen:
- EP-A1- 1 058 286
- WO-A1-98/36796
- WO-A1-2004/025682
- US-A- 5 229 682
- US-A1- 2003 021 377

## Beschreibung

Die Erfindung betrifft eine Röntgenquelle zur Ionisierung von Gasen mit einem Feldemissions-Spitzen-Array in einer Vakuumkammer.

Solche Röntgenquellen zur Ionisierung von Gasen bestehen aus mehreren einzelnen Röntgenquellen, welche mittels eines balkenförmigen Trägers längs aneinander gereiht sind und mit einer notwendigen Spannung versorgt werden. Die Röntgenquellen sind dabei derart in einem Luftstrom montiert, dass sie die Umgebungsluft der balkenförmigen Anordnung ionisieren. Die auf diese Weise ionisierte Luft kann zur Neutralisation von elektrostatischen Aufladungen in kritischen Fertigungsbereichen genutzt werden.

Beispielsweise können derartige Röntgenquellen in die zumeist vertikale Luftströmung im Reinraum von Fertigungsanlagen in der Mikroelektronik-Industrie eingesetzt werden, um mit Hilfe der ionisierten Gase elektrostatische Aufladungen auf Gegenständen zu neutralisieren. Das ist notwendig, weil elektrostatische Aufladungen zu verstärkten Partikelablagerungen führen. Andererseits können unkontrollierte Entladungen zu Schädigungen der Mikrostrukturen führen. Die elektrostatischen Entladungen werden als ESD (ElectroStatic Discharge) bezeichnet. Auch werden Ionengeneratoren eingesetzt, um eine vorgegebene Ionendichte unterschiedlich geladener Ionen innerhalb einer Kabine oder eines anderen Raumes zu realisieren, wobei unmittelbar nach der Erzeugung der Ionen gewöhnlich deren Rekombination einsetzt.

Die üblicherweise eingesetzten Ionisationssysteme erzeugen die Ionen mittels Hochspannung an Spitzenelektroden über Gasentladung. Dabei kommt sowohl Gleichspannung, als auch Wechselspannung, oder sogenannte gepulste Gleichspannung, zum Einsatz. Es werden somit unterschiedliche Verfahren angewendet, um die Rekombination von positiven und negativen Ionen zu minimieren. Ein wesentlicher Aspekt dieser Ionisatoren ist ein ausgewogenes Verhältnis von positiven und negativen Ionen zu erreichen, um eine vollständige Neutralisation der Aufladungen sicher zu stellen.

So geht aus der DE 600 34 040 T2 eine Ionengenerator-Vorrichtung hervor, bei der mehrere nebeneinander aufrecht stehende Emissionsnadeln aus Titan, Platin, einer Titan-Platin-Verbindung, oder auch aus rostfreiem Metall, bzw. aus verschiedenen, Legierungen eingesetzt werden. Die Emissionsnadeln bestehen aus einem zylindrischen Kern, der von einem Verbundwerkstoff aus einer ungesättigten Polyesterverbindung, enthaltend Glasfasern, umgeben wird. Jede Nadelspitze endet außerhalb eines Gehäuses in einer konischen Vertiefung, die durch ein Gitter abgedeckt sein kann. An der Nadelspitze wird ein starkes Spannungsfeld oder eine Potentialdifferenz entlang der Nadel erzeugt, um die Erzeugung von Elektronen durch die Emissionsspitzen zu gewährleisten. Dazu sind die Nadeln mit einer Hochspannungsquelle mit einer Hochspannung von 4,3 - 6 kV direkt verbunden. Die Nadelspitzen können zusätzlich mit einem Goldfilm überzogen sein.

Weiterhin geht aus der DE 691 11 651 T2 ein Reinraum-Corona-Luftionisator hervor, der mit mindestens einer Coronaspitze ausgestattet ist, die mit einer Hochspannungsquelle verbunden ist. Die Coronaspitze befindet sich innerhalb eines einseitig geschlossenen Rohres und wird durch ein trockenes wasserstoffreiches Gas umströmt. Dieser Corona-Luftionisator ermöglicht die Entfernung von Mikroverunreinigungen, wie Ammoniumnitrat-Anreicherungen, die bei Corona-Ionisatoren entstehen können.

In der DE 698 18 364 T2 werden Germanium Emittorelektroden verwendet, um metallische Verunreinigungen bei der Produktion von integrierten Schaltungen auf das niedrigst mögliche Niveau zu drücken. Die Emittorelektrode hat eine Spitze, die in einem kugelförmigen Radius endet. Die Germaniumemitter sind halbleitend und besitzen einen spezifischen Widerstand zwischen ungefähr 0,1 - 100 Qcm. Um das zu erreichen, sind die Germaniumemitter bevorzugt mit Antimon dotiert.

Die US 5 729 583 bezieht sich auf eine niederenergetische Miniatur-Rötgenstrahlenquelle für die diagnostische Radiographie mit einem in einer Vakuumkammer angeordneten Emissionsspitzenarray auf einer Kathodenfläche und wobei über dem Emissionsspitzenarray eine flächige Gateanordnung vorgesehen ist. Die zugehörige Anode erstreckt sich in der Vakuumkammer in Form einer Metallfolie entlang der Innenwand und vor einem Kollimator vor dem Emissionsspitzenarray. Die Emissionsspitzen befinden sich in zylindrischen Öffnungen in der flächigen Gateanordnung und einer Isolationsschicht, die sich zwischen der Kathodenfläche und der Gateanordnung erstreckt.

Eine ähnliche Konstruktion für ein Emissionsspitzenarray geht aus der US 3 665 241 hervor.

In der EP 1 058 286 A1 wird eine Miniaturröntgenquelle beschrieben, die aus einem Basiselement aus Silizium, einem anderen Halbleitermaterial, oder Glas bzw. keramischen Materialien oder Metall bestehen kann und einem Deckel, wobei zwischen dem Basiselement und dem Deckel ein Isolator angeordnet ist und der einen Innenraum zwischen Basiselement und Deckel umschließt. In einer Vertiefung im Basiselement befinden sich eine Kathode, die aus einer Schicht aus einem geeigneten Material, vorzugsweise Diamant, besteht und aus der eine Vielzahl von Mikrospitzen hervorstehen. Ein Teil des Deckels dient zugleich als Anode, die aus W, Au, Pt, Ir.

Beim Anlegen eine Spannung zwischen Anode und Kathode werden Elektronen emittiert und in Richtung zur Anode beschleunigt und bei deren Auftreffen auf die Anode entstehen Wärme und Röntgenstrahlung.

Die WO 98/36796 A1 bezieht sich ebenfalls auf eine miniaturisierte Strahlungsquelle, die aus einer unteren und einer oberen Platte besteht, die einen Mikrohohlraum einschließen. Am Boden des Mikrohohlraumes befindet sich eine Spitze mit extrem kleinen Außenmaßen als Kathode. Auf der Innenseite der oberen Platte befindet sich ein Anodenmaterial, wie beispielsweise Wolfram.

Die Anode kann auch mit einer großen Anzahl von Mikrospitzen versehen sein, die aus Diamantpartikeln bestehen können.

Weiterhin geht aus der US 5229 682 eine Elektronen emittierende Vorrichtung hervor, die aus einem Siliziumsubstrat besteht und die mit einer Isolierschicht abgedeckt ist. In der Isolierschicht befindet sich eine Öffnung, in der aus dem Siliziumsubstrat eine Spitze oder mehrere Spitzen als Kathode hervorstehen. Weiterhin befindet sich auf der Isolierschicht eine Gateelektrode, die über der Spitze in der Öffnung diese konzentrisch umgrenzt.

Aus der DE 10 2009 031 985 A1 geht ein Ionisator mit mehreren in einem Kreisumfang angeordneten Elektrodenpaaren mit unterschiedlicher Länge der Elektroden hervor, die in eine Luftströmung hineinragen, bei dem sich die Strömungen der positiven und negativen Ionen nicht überlappen. Auf diese Weise reduziert sich die Menge der durch Neukombination neutralisierten Ionen, so dass die Entladungseffizienz am zu schützenden Werkstück verbessert wird.

In den meisten Fällen besitzen die eingesetzten Systeme jedoch eine Balkenform, bei der an der Unterseite die Emitterspitzen herausragen, die in die Hochspannungsversorgung integriert sind.

Ein typisches Beispiel für ein solches System geht aus der US 6 807 044 B1 hervor. Dabei trägt ein balkenförmiger Tragbalken nebeneinander eine Vielzahl von spitzen Emitterelektroden, die jeweils innerhalb einer einseitig offenen rohrförmigen Umhüllung untergebracht sind. Der Tragbalken wird durch ein Gehäuse umschlossen, in dem die notwendige Spannungsversorgung untergebracht ist.

Ähnliche balkenförmige Ionisierungsvorrichtungen werden auch in der WO 2009/031764 A2 und der JP 2010 218696 A beschrieben.

Derartige Ionisierungsvorrichtungen werden üblicherweise in einer Luftströmung angeordnet, die von einer Reinstluftanlage erzeugt wird und die auf die zu schützenden Werkstücke, wie Halbleiterwafer, oder andere sensible Fertigungseinrichtungen gerichtet sind.

Derartige mit Hochspannung betriebene Gasentladungs-Ionisationssysteme haben eine Reihe von Nachteilen. So ist die Balance zwischen den generierten negativen und positiven Ionen sehr stark abhängig von der Hochspannungsversorgung und der geometrischen Anordnung der Emitterelektroden. D.h. es gibt gepulste oder Wechsel-Hochspannungssysteme, bei denen in zeitlicher Folge positive und negative Ionen nacheinander erzeugt werden.

Gleichspannungssysteme haben örtlich versetzte Emitterelektroden für positive und negative Hochspannung. Damit werden die jeweilig polaren Ionen an verschiedenen Stellen erzeugt, was wiederum zu Ungleichgewichten in der Polaritätsverteilung und damit zu Aufladevorgängen im Einflussbereich führt. In jedem Fall handelt es sich um ortsabhängige Aufladevorgänge.

Weiterhin ist die Polaritätsbalance über die Zeit nicht stabil, da sich die Emitterelektroden im Laufe der Zeit verändern. Die Hochspannungsionisatoren müssen folglich ständig kontrolliert und nachjustiert werden.

Neben den Einflüssen durch unterschiedliche Ionenkonzentrationen gibt es noch ungewollte Einflüsse von der Ionen erzeugenden Hochspannung an den Emittern, die häufig über 15 kV liegt.

Insbesondere in Einbausituationen, in denen die zu neutralisierenden Produkte nahe an die Ionisatoren herankommen, entstehen zum Teil erhebliche Potentialdifferenzen durch die elektrische Feldinfluenz.

Darüber hinaus entstehen an den Emitterelektroden selbst unter reinsten Luftbedingungen partikuläre Verunreinigungen durch elektrochemische Umwandlungsprozesse, die für die hochreinen Fertigungen der Mikrostrukturindustrie eine Qualitätsgefährdung bedeuten. Die Emitter von Hochspannungsionisatoren müssen daher regelmäßig gereinigt werden, was mit einer Unterbrechung des Produktionsablaufes verbunden ist.

Mit den immer kleiner werdenden Strukturen werden die Empfindlichkeiten der Substrate gegenüber elektrostatischen Aufladungen immer größer. Mit den heutigen Strukturgrößen sind die Grenzen der verwendeten Hochspannungsionisatoren offensichtlich und es wird nach anderen Möglichkeiten gesucht.

So sind Ionisationssysteme im Markt erhältlich, die mittels niederenergetischer Röntgenstrahlung Luftionen erzeugen. Dabei wird zunehmend ein Energiebereich unter 5 keV genutzt. Diese Systeme, bei denen Röntgenröhren eingesetzt werden, haben den Vorteil, dass sie keinerlei elektrische Feldwirkung nach außen haben und die Ionen-Polaritätsbalance immer perfekt ausgewogen ist. Das liegt daran, dass die Ionen im Luftvolumen mittels der ionisierenden Strahlung durch Abspalten eines Elektrons und dem entsprechenden Verbleib des positiven Rumpfions generiert werden. Darüber hinaus entstehen keine Kontaminationen.

Von Nachteil bei diesen Systemen sind zum Einen der relativ hohe Preis und zum Anderen die geringe Lebensdauer der benutzten Röntgenröhren. Bei den aktuell eingesetzten Systemen kommen Röntgenröhren mit Glühkathode zum Einsatz, die in der Regel eine Lebensdauer von etwa einem Jahr aufweisen. Das bedeutet, dass die Röntgenröhren jährlich zeit- und kostenaufwendig ausgetauscht werden müssen.

Ein weiterer Nachteil dieser Systeme ist darin zu sehen, dass sie recht voluminös und daher häufig schlecht in Anlagen integrierbar sind und enthalten zusätzlich die für die Glühkathoden notwendige und relativ aufwändige Regelungselektronik und Überwachung.

Ein Beispiel für einen solchen In-Line Gas Ionisierer geht aus der WO 01/84683 A2 hervor. Dieser Ionisierer umfasst eine Druckluftquelle mit einem Luftkanal zur Fertigungseinrichtung und einer Röntgenstrahlungsquelle, die in den Luftkanal integriert ist.

Der Erfindung liegt nun die Aufgabe zugrunde, eine Vorrichtung zur Ionisierung von Gasen zu schaffen, welche zum Einen die einfache, kompakte und kosteneffektive Bauform und Anordnung der balkenförmigen Hochspannungsionisatoren mit den Vorteilen niederenergetischer Röntgen-Ionisatoren verbindet und die zum Anderen die Nachteile der bekannten Röntgensysteme vermeidet.

Gelöst wird die Aufgabe dadurch, dass ein Feldemissions-Spitzen-Array mit Feldemissionsspitzen innerhalb eines Vakuumbereiches angeordnet ist, der durch eine metallische Haube und einen Teil einer metallischen Trägerplatte umschlossen ist, wobei das mit Feldemissionsspitzen versehene Feldemissions-Spitzen-Array gegenüber der Trägerplatte elektrisch isoliert auf oder über einem Isolierkörper in der Trägerplatte auf einer sich durch den Isolierkörper erstreckenden Elektrode angeordnet sowie mit dieser elektrisch verbunden und als Kathode geschaltet mit einer Hochspannungsquelle verbunden ist, wobei zentrisch über dem Feldemissions-Spitzen-Array in der Haube ein für Röntgenstrahlung durchlässiges Transmissionsfenster angeordnet ist, das aus Beryllium oder einem anderen geeigneten Material, wie Diamant, besteht und auf der Vakuumseite mit Wolfram oder einem anderen Bremsmaterial beschichtet ist und wobei die Haube als Anode geschaltet ist.

Das Feldemissions-Spitzen-Array besteht aus einem flachen quaderförmigen Grundkörper, aus dem eine Vielzahl von Feldemissionsspitzen hervor steht.

Die Feldemissionsspitzen sind bevorzugt spitzkegelig, oder auch stabförmig ausgebildet, stehen aus dem quaderförmigen Grundkörper senkrecht hervor und sind in einem gleichmäßigen Array über die Fläche des Grundkörpers verteilt angeordnet.

Zur Vermeidung besonders hoher Feldstärken enden die Feldemissionsspitzen in einer Fortbildung der Erfindung in abgerundeten Spitzen.

Das Feldemissions-Spitzen-Array besteht aus Metall, oder einem Halbleitermaterial.

In einer besonderen Ausgestaltung der Erfindung sind die Feldemissionsspitzen durch einen Isolator derart umgeben, dass der die Spitzen der Feldemissionsspitzen umgebende Bereich in Form eines Kraters ausgespart ist und dass die Feldemissionsspitzen in einem in Richtung zur Spitze der Feldemissionsspitze sich vulkankegelartig verjüngenden Kragen münden, der die Feldemissionsspitzen als Gate konzentrisch und den Krater umgrenzt.

Die Spitzen der Feldemissionsspitzen können aus dem Kragen herausragen.

Weiterhin sind zwischen den benachbarten Kragen Senken ausgebildet, wobei die gesamte Oberfläche des Feldemissions-Spitzen-Arrays außer dem im Kragen befindlichen Krater mit einer Metallschicht überzogen ist.

In Fortführung der Erfindung ist die Haube mit der Trägerplatte vakuumdicht verbunden, wobei die Trägerplatte mit Erdpotential verbunden ist.

Das Feldemissions-Spitzen-Array ist innerhalb des Vakuumbereiches auf einer Elektrode angeordnet und ist mit dieser elektrisch verbunden, wobei sich die Elektrode durch den Isolierkörper erstreckt.

Um eine Steuerung des Anodenstromes zu ermöglichen, ist eine Gate-Elektrode über eine Drahtbrücke mit der Metallschicht der Feldemissions-Spitzen-Anordnung elektrisch leitend verbunden, wobei die Gate-Elektrode neben der Elektrode den Isolierkörper durchdringt.

Der Spitzenradius der Feldemissionsspitzen beträgt bevorzugt 2 nm, so dass eine hohe Feldliniendichte in Richtung zur Anode erreicht wird.

Weiterhin beträgt die an der Gate-Elektrode anliegende Spannung 20 - 100 V und die Betriebsspannung der Röntgenquelle <5 kV und beträgt bevorzugt an dem als Kathode geschalteten Feldemissions-Spitzen-Array zwischen -4.980 und -4.900 V

Die miniaturisierte Röntgenquelle eignet sich besonders zur Verwendung mit einem balkenförmigen mehrteiligen Tragsystem, das aus einem balkenförmigen hohlen Tragprofil besteht, in das auf einer Längsseite ein aus Metall bestehendes Tragprofil isoliert eingelassen ist und auf dem eine Mehrzahl der Röntgenquellen in der Längserstreckung des Tragprofiles abstandsweise nebeneinander derart befestigt sind, dass sich die Elektroden in das Tragprofil erstrecken und mit längs des Tragprofiles verlaufenden Hochspannungszuführungen verbunden sind und dass die Röntgenquellen in die Umgebung des Tragsystems ragen und wobei der Innenraum der Tragprofiles mit einer Hochspannungsisolierung ausgefüllt ist.

Bei der vorliegenden Erfindung kommt daher eine miniaturisierte, niederenergetische Röntgenquelle zum Einsatz, welche als Kathode ein Mikro-Spitzen-Array nutzt, welches an sich für andere Anwendungsfälle bekannt ist. Mit der Verwendung eines solchen Spitzen-Arrays als Kathode, welches die Elektronen auf der Basis des quantenmechanischen Tunneleffekts bei hohen Feldstärken an den Spitzen erzeugt, können Lebenszeiten von mehreren Jahren sichergestellt werden. Auch wird die Nutzung von Fertigungsverfahren der Mikroelektronik, die für die Massenproduktion von kleinen Bauteilen ausgelegt ist ermöglicht, was zu akzeptablen Kosten führt.

Mit der Miniaturisierung der Röntgenquelle ist dann der Aufbau in der bewährten Balkenform möglich, so dass die einfache Spannungsversorgung und Überwachungselektronik für beliebig viele anreihbare Röntgenquellen integriert werden kann.

Die Erfindung soll nachfolgend an Ausführungsbeispielen näher erläutert werden. In den zugehörigen Zeichnungen zeigen:
- Fig. 1:: eine miniaturisierte Röntgenquelle mit einem Feldemissions-Spitzen Array innerhalbe eines Vakuumbereiches;
- Fig. 1a:: eine mit einer "Gate"-Anordnung versehene Röntgenquelle nach Fig.1;
- Fig. 2:: eine Ausführung der Röntgenquelle nach Fig. 1a als Bestandteil eines balkenförmigen Tragsystems, und
- Fig. 3:: einen Querschnitt des Feldemissions-Spitzen-Arrays nach Fig. 1.

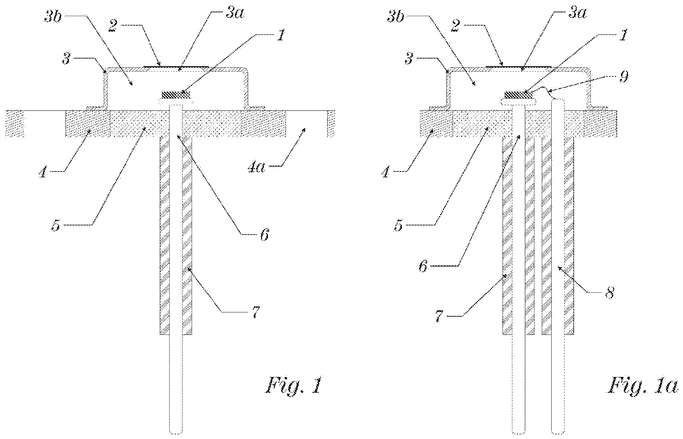

In Fig. 1 ist eine miniaturisierte niederenergetische Röntgenquelle dargestellt, die mit einem Feldemissions-Spitzen-Array 1 ausgestattet ist, das auf einer Elektrode 6 oberhalb eines Isolierkörpers 5, oder auf diesem, montiert ist. Die elektrische und mechanische Verbindung zwischen dem Feldemissions-Spitzen-Array 1 und der Elektrode 6 (Kathode) erfolgt durch Chipbonden bzw. mit Hilfe eines elektrisch leitfähigen Klebstoffes. Der Isolierkörper 5 ist bündig und vakuumdicht in eine metallische Trägerplatte 4 eingelassen, oder auf dieser angeordnet, wobei die Elektrode 6 den Isolierkörper 5 durchdringt. Die Elektrode 6 wird mit der notwendigen Kathodenspannung einer geeigneten Hochspannungsquelle versorgt.

Das Feldemissions-Spitzen-Array 1 besteht aus einem quaderförmigen Grundkörper 18 aus Metall oder einem Halbleitermaterial, aus dem eine Vielzahl von Feldemissionsspitzen 19 senkrecht hervor steht, die in einem Array mit regelmäßigen Abständen zueinander angeordnet sind. Die Feldemissionsspitzen 19 können spitzkegelig oder stabförmig ausgebildet sein und können abgerundete Enden aufweisen. Ein solches Feldemissions-Spitzen-Array 1 kann mit Fertigungsverfahren der Mikrostrukturierungstechnik, wie sie aus der Halbleitertechnologie bekannt sind, hergestellt werden.

Zur Ausbildung eines das Feldemissions-Spitzen-Array 1 umgebenden Vakuumbereiches 3b wird dieser durch eine aus einem Metall bestehende Haube 3 umschlossen, die mit der Trägerplatte 4 elektrisch leitend und vakuumdicht verbunden ist. Die Haube 3 dient als Anode und ist mit Masse verbunden. Der Aufbau der erfindungsgemäßen Röntgenquelle entspricht grundsätzlich dem eines Gehäuses für Leistungstransistoren, wie einem TO-5 oder TO-39 Gehäuse.

Um eine gegenüber den bisher verwendeten Glühkathoden deutlich verbesserte Lebensdauer und Langlebigkeit des Feldemissions-Spitzen-Arrays 1 zu gewährleisten, müssen jegliche Sputtervorgänge durch Restgasatome vermeiden werden. Das bedeutet, je besser das Vakuum ist, umso höher ist die Lebensdauer. Praktisch wäre daher ein Vakuum von <10^-6 hPa vorzusehen.

Zentrisch über dem Feldemissions-Spitzen-Array 1 befindet sich in der Haube 3 eine Bohrung 3a, die mit einem üblichen Transmissionsfenster 2 für Röntgenquellen, wie z.B. einer Beryllium-Fläche, verschlossen ist und die auf der Vakuumseite mit Wolfram als Bremsmaterial beschichtet ist, wobei auch andere geeignete Materialien als Bremsmaterial eingesetzt werden können. Es ist auch möglich, die Bohrung 3a mit anderen geeigneten Fenstervarianten zu verschließen, die für Röntgenstrahlung durchlässig sind. Die Haube 3 und die Trägerplatte 4 befinden sich auf dem gleichen Potential und sind mit einem Anodenpotential der Hochspannungsquelle, d.h. mit Masse bzw. Erdpotential, verbunden.

Das Transmissionsfenster 2 kann auch aus anderen Materialien bestehen, die für Röntgenstrahlen gut durchlässig sind, wie beispielsweise Diamant. Weiterhin ist die Trägerplatte 4 mit Befestigungsbohrungen 4a versehen, um diese zwecks guter Wärmeabfuhr mit einem nicht dargestellten balkenförmigen Träger zu verschrauben, oder anderweitig verbinden zu können.

Um eine ausreichende Hochspannungskriechstrecke zu gewährleisten, ist die Elektrode 6 unterhalb des Isolierkörpers 5 auf der atmosphärischen Seite mit einer Isolierung 7 ummantelt.

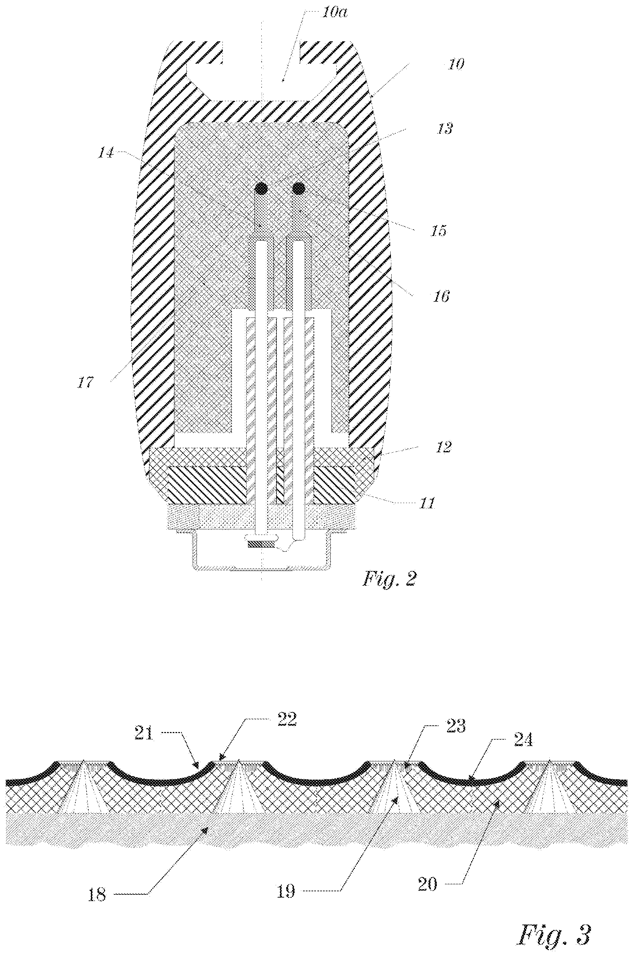

Das Feldemissions-Spitzen-Array 1 kann zur Steuerung des Anodenstromes auch mit einer "Gate"-Anordnung versehen sein, wie in Fig. 1a und Fig. 3 schematisch dargestellt ist.

Eine solche "Gate"-Anordnung kann durch eine separate Gate-Elektrode 8 realisiert werden, die durch Drahtbonden und Herstellen einer Drahtbrücke 9 mit der Feldemissions-Spitzen-Anordnung 1 elektrisch leitend verbunden ist. Die Gate-Elektrode 8 ist neben der Elektrode 6 angeordnet, durchdringt den Isolierkörper 5 und ragt in den Vakuumbereich 3b hinein. Unterhalb des Isolierkörpers 5, d.h. auf der atmosphärischen Seite, ist die Gate-Elektrode 8 ebenfalls mit einer Isolierung 7 ummantelt. Ansonsten entspricht diese Variante der Ausführung nach Fig. 1.

Aus Gründen der Potentialverteilung sollte der Abstand zwischen den Spitzen des Feldemissions-Spitzen-Arrays 1 zur Anode, d.h. der Beryllium-Fläche des Transmissionsfensters 2, sehr viel größer sein, als den Abstand zwischen den Spitzen des Feldemissions-Spitzen-Arrays 1 und der Gate-Elektrode 8, die durch einen nachfolgend beschriebenen Kragen gebildet wird. Der Spitzen-Gate-Abstand liegt zwischen 100 bis 500 nm. Das bedeutet, dass der Anodenabstand mindestens bei 100 - 500 µm liegt, wobei der Abstand aus Gründen der mechanischen Handhabung eher bei 1 - 3 mm gewählt wird.

In Fig. 3 ist ein Querschnitt eines Ausschnitts des auf einem Grundkörper 18 aufgebauten Feldemissions-Spitzen-Arrays 1 entsprechend Fig. 1 mit in einem regelmäßigen Array angeordneten Feldemissionsspitzen 19 dargestellt. Die Feldemissionssitzen 19 werden im Wesentlichen allseitig durch einen Isolator 20, wie SiO₂, umhüllt, wobei lediglich der die Spitzen der Feldemissionsspitzen 1 unmittelbar umgebende Bereich kraterähnlich freigehalten ist.

Die Feldemissionsspitzen 19 erstrecken sich durch den Isolator 20 und münden mit ihrer Spitze jeweils in einem sich in Richtung der Feldemissionsspitze 19 vulkankegelähnlich verjüngenden Kragen 21, der aus einem leitfähigen Material besteht und der die aus dem Krater 23 hervorstehende Spitze der Feldemissionsspitzen 19 als Gate konzentrisch umgibt. Der Krater 23 wird zugleich durch den Kragen 21 umgrenzt. Die Feldemissionsspitzen 19 können aus dem Kragen 21 hervorstehen, also diesen überragen. Der die Feldemissionsspitzen 19 umgebende Rand des Kragens 21 ist mit dem Gate 8 verbunden.

Der Bereich zwischen den Kragen 21 bildet jeweils eine Senke, die sich bis zum jeweils benachbarten Kragen erstreckt, wobei die gesamte Oberfläche des Feldemissions-Spitzen-Arrays 1, außer dem im Kragen 21 befindlichen Krater 23, mit einer Metallschicht 24 überzogen ist.

Fig. 2 zeigt eine Ausführung der Röntgenquelle nach Fig. 1a als Bestandteil eines balkenförmigen Tragsystems, wobei mehrere Röntgenquellen in der Längserstreckung des Tragsystems nebeneinander angeordnet sind. Das balkenförmige Tragsystem für die erfindungsgemäßen miniaturisierten Röntgenquellen besteht aus einem langgestreckten Tragprofil 10 aus Metall oder Kunststoff, das beispielsweise durch Extrudieren hergestellt werden kann. Innerhalb des Tragprofiles 10 befindet sich an geeigneter Stelle die notwendige Versorgung für die Kathodenspannung und auch für die Gate-Spannung, falls eine Gate-Elektrode 8 zur Steuerung des Anodenstromes vorgesehen ist.

Die erfindungsgemäß miniaturisierte, niederenergetische Röntgenquelle erzeugt Elektronen auf der Basis eines quantenmechanischen Tunneleffekts bei hohen Feldstärken, wobei eine Nutzungsdauer von mehreren Jahren sichergestellt werden kann. Die Fertigung der miniaturisierten Röntgenquelle kann problemlos und kostengünstig unter Nutzung der Fertigungsverfahren der Mikroelektronik erfolgen.

Die miniaturisierte Röntgenquelle nach Fig. 1 oder 1a ist an dem balkenförmigen mehrteiligen Tragsystem mit dem Profil 10, wie in Fig. 2 dargestellt, befestigt. Das Tragprofil 10 ist auf einer Seite - in Fig. 2 oben - mit einer Befestigungsnut 10a ausgestattet, so dass das Tragprofil 10 an einer geeigneten ortsfesten Halterung befestigt werden kann. Auf der der Befestigungsnut gegenüber liegenden Seite ist ein extrudiertes metallisches Befestigungsprofil 11 zur Befestigung der erfindungsgemäßen miniaturisierten Röntgenquelle vorgesehen, das in ein Kunststoffprofil 12 angeordnet ist, welches in eine Vertiefung im Tragprofil 10 eingelassen ist und somit eine elektrische Isolierung zwischen dem Tragprofil 10 und dem Befestigungsprofil 11 herstellt. Die elektrische Isolierung zwischen dem Befestigungsprofil 11 und dem Tragprofil 10 ist nur notwendig, wenn letzteres aus Metall besteht.

Die erfindungsgemäßen miniaturisierten Röntgenquellen sind in vorgegebenen Abständen an dem Befestigungsprofil 11 befestigt, das neben der mechanischen Befestigung auch der elektrischen Kontaktierung der typischerweise auf Erdpotential liegenden Anode der Röntgenquellen, d.h. der Haube 3 und der Trägerplatte 4, dient. Dabei erstrecken sich die Elektroden 6, 8 in das Tragprofil 10 und sind mit längs des Befestigungsprofils 11 verlaufenden Hochspannungszuführungen 13, 15 verbunden. Die Röntgenquellen ragen dabei aus dem Tragsystem in die Umgebung. Durch das Kunststoffprofil 12 ist es möglich, den Anodenstrom über eine am Befestigungsprofil angeschlossene Messelektronik zu messen, indem diese mit dem Erdpotential verbunden wird. Auf diese Weise lässt sich eine Funktionsüberwachung der miniaturisierten Röntgenquelle realisieren.

In dem Tragprofil 10 befinden sich längs verlaufend eine Hochspannungszuführung 13 für die Kathode und ggf. eine Hochspannungszuführung 15 für die Gate-Elektrode 8. Weiterhin ist der Innenraum des Tragprofiles 10 mit einer Hochspannungsisolierung 17 vergossen. Weiterhin sind die Elektrode 6 und die Gate-Elektrode 8 in entsprechende Buchsen 14 und 16 eingesteckt, die mit den Hochspannungszuführungen 13 und 15 elektrisch verbunden sind.

Die Betriebsspannung für die Röntgenquelle sollte aus praktischen Erwägungen im Bereich von <5 kV liegen, da der administrative Aufwand in diesem Energiebereich deutlich geringer ist, weil die in diesem Bereich erzeugten ionisierenden Strahlen zumeist nicht als Röntgenstrahlungsquellen angesehen werden. Die erfindungsgemäße Röntgenquelle kann aber problemlos auch mit einer höheren Betriebsspannung betrieben werden, wenn das notwendig ist.

Während des Betriebes der erfindungsgemäßen Röntgenquelle werden aus den Spitzen des Feldemissions-Spitzen-Arrays 1 auf Grund der hohen Feldstärke an den Spitzen Elektronen durch Feldemission extrahiert, wobei die Feldstärke an den Spitzen durch den Potentialunterschied zwischen Spitze und Gate sowie deren geometrische Anordnung bestimmt wird.

Beispielsweise wird eine Feldstärke von 10^9 V/m bei einem Spitzenradius von 2 nm, einem ringförmigen Gate mit 100 nm Durchmesser auf Spitzenebene und einem Gate-Potential gegenüber den Spitzen von 60 V erreicht.

Die ausgetretenen Elektronen werden dann hinter dem Gate durch die Beschleunigungs-Hochspannung zwischen Kathode und Anode auf letztere beschleunigt. Die beschleunigungs-Hochspannung bleibt während des Betriebes der Röntgenquelle konstant, da durch diese Spannung die maximale Strahlungsenergie bestimmt wird.

Die Gate-Spannung sollte in einem Bereich von 20-100 V regelbar sein, wobei als Regelparameter der zu messende Anodenstrom dient. Kathode und Gate liegen bei <-5000 V (Kathodenspitzen) bzw. -4980 bis - 4900 V (Gate Ring), wobei die Anode auf Massepotential liegt. Die Kathode-Gate Spannung wird über Opto-Koppler galvanisch getrennt, von einem Controller geregelt.

### Röntgenquelle zur Ionisierung von Gasen

### Bezugszeichenliste

- 1: Feldemissions-Spitzen-Array
- 2: Transmissionsfenster
- 3: Haube
- 3a: Bohrung
- 3b: Vakuumbereich
- 4: Trägerplatte
- 4a: Befestigungsbohrungen
- 5: Isolierkörper
- 6: Elektrode
- 7: Isolierung
- 8: Gate-Elektrode
- 9: Drahtbrücke
- 10: Tragprofil
- 10a: Befestigungsnut
- 11: Befestigungsprofil
- 12: Kunststoffprofil
- 13: Hochspannungszuführung
- 14: Buchse
- 15: Hochspannungszuführung
- 16: Buchse
- 17: Hochspannungsisolierung
- 18: Grundkörper
- 19: Feldemissionsspitze
- 20: Isolator
- 21: Kragen
- 22: Gate
- 23: Krater
- 24: Metallschicht

## Patentansprüche

1. Röntgenquelle zur Ionisierung von Gasen mit einem Feldemissions-Spitzen-Array in einer Vakuumkammer, wobei das Feldemissions-Spitzen-Array (1) mit Feldemissionsspitzen (19) innerhalb eines Vakuumbereiches (3b) angeordnet ist, der durch eine metallische Haube (3) und einen Teil einer metallischen Trägerplatte (4) umschlossen ist, und wobei das Feldemissions-Spitzen-Array (1) gegenüber der Trägerplatte (4) elektrisch isoliert auf oder über einem Isolierkörper (5) in der Trägerplatte (4) auf einer sich durch den Isolierkörper (5) erstreckenden Elektrode (6) angeordnet sowie mit dieser elektrisch verbunden ist und als Kathode geschaltet mit einer Hochspannungsquelle verbunden ist und wobei zentrisch über dem Feldemissions-Spitzen-Array (1) in der Haube (3) ein für Röntgenstrahlung durchlässiges Transmissionsfenster (2) angeordnet ist, das aus Beryllium oder einem anderen geeigneten Material, wie Diamant, besteht und auf der Vakuumseite mit Wolfram oder einem anderen Bremsmaterial beschichtet ist und wobei die Haube (3) als Anode geschaltet ist.

2. Röntgenquelle nach Anspruch 1, **dadurch gekennzeichnet, dass** das Feldemissions-Spitzen-Array (1) aus einem flachen quaderförmigen Grundkörper besteht, aus dem eine Vielzahl von Feldemissionsspitzen (19) hervor stehen.

3. Röntgenquelle nach Anspruch 2, **dadurch gekennzeichnet, dass** die Feldemissionsspitzen (19) spitzkegelig oder stabförmig ausgebildet sind, aus einem quaderförmigen Grundkörper (18) senkrecht hervorstehen und in einem gleichmäßigen Array über die Fläche des Grundkörpers (18) verteilt angeordnet sind.

4. Röntgenquelle nach Anspruch 3, **dadurch gekennzeichnet, dass** die Feldemissionsspitzen (19) abgerundete Enden aufweisen.

5. Röntgenquelle nach Anspruch 1 bis 4, **dadurch gekennzeichnet, dass** das Feldemissions-Spitzen-Array (1) aus Metall, oder einem Halbleitermaterial besteht.

6. Röntgenquelle nach einem der vorstehenden Ansprüche 1 bis 5, **dadurch gekennzeichnet, dass** die Feldemissionsspitzen (19) des Feldemissions-Spitzen-Arrays (1) durch einen Isolator (20) derart umgeben sind, dass der die Spitzen der Feldemissionsspitzen (19) umgebende Bereich in Form eines Kraters (23) ausgespart ist, und dass die Feldemissionsspitzen (19) in einem sich in Richtung zur Spitze der Feldemissionsspitze (19) vulkankegelähnlich verjüngenden metallischen Kragen (21) münden, der die Feldemissionsspitzen (19) als leitfähiges Gate konzentrisch umgibt und den Krater (23) umgrenzt.

7. Röntgenquelle nach Anspruch 6, **dadurch gekennzeichnet, dass** die Feldemissionsspitzen (19) aus dem Kragen (21) herausragen.

8. Röntgenquelle nach Anspruch 6 und 7, **dadurch gekennzeichnet, dass** zwischen den benachbarten Kragen (21) Senken (24) ausgebildet sind, wobei die gesamte Oberfläche des Feldemissions-Spitzen-Arrays (1) außer dem im Kragen (21) befindlichen Krater (23) mit einer Metallschicht (24) überzogen ist.

9. Röntgenquelle nach einem der vorstehenden Ansprüche 1 bis 8, **dadurch gekennzeichnet, dass** die Haube (3) mit der Trägerplatte (4) vakuumdicht verbunden ist und wobei die Trägerplatte (4) mit Erdpotential verbunden ist.

10. Röntgenquelle nach einem der vorstehenden Ansprüche 1 bis 9, **dadurch gekennzeichnet, dass** das Feldemissions-Spitzen-Array (1) innerhalb des Vakuumbereiches (3b) auf einer Elektrode (6) angeordnet und mit dieser elektrisch verbunden ist, die sich durch den Isolierkörper (5) erstreckt.

11. Röntgenquelle nach einem der Ansprüche 1 bis 10, **dadurch gekennzeichnet, dass** eine Gate-Elektrode (8) über eine Drahtbrücke (9) mit der Metallschicht (24) der Feldemissions-Spitzen-Anordnung (1) elektrisch leitend verbunden ist, wobei die Gate-Elektrode (8) neben der Elektrode (6) den Isolierkörper (5) durchdringt.

12. Röntgenquelle nach einem der Ansprüche 1 bis 11, **dadurch gekennzeichnet, dass** der Spitzenradius der Feldemissions-spitzen (19) ca. 2 nm beträgt.

13. Röntgenquelle nach einem der Ansprüche 1 bis 12, **dadurch gekennzeichnet, dass** die an der Gate-Elektrode (8) anliegende Spannung 20 - 100 V beträgt.

14. Röntgenquelle nach einem der Ansprüche 1 bis 13, **dadurch gekennzeichnet, dass** die Betriebsspannung der Röntgenquelle <5 kV und bevorzugt an dem als Kathode geschalteten Feldemissions-Spitzen-Array (1) bevorzugt zwischen -4980 und -4900 V beträgt.

15. Verwendung der Röntgenquelle nach den Ansprüchen 1 bis 14 in einem balkenförmigen mehrteiligen Tragsystem, das aus einem balkenförmigen hohlen Tragprofil (10) besteht, in das auf einer Längsseite ein aus Metall bestehendes Tragprofil (11) isoliert eingelassen ist und auf dem eine Mehrzahl der Röntgenquellen in der Längserstreckung des Tragprofiles (11) abstandsweise nebeneinander derart befestigt sind, dass sich die Elektroden (6, 8) in das Tragprofil (10) erstrecken und mit längs des Befestigungsprofils (11) verlaufenden Hochspannungszuführungen (13, 15) verbunden sind und dass die Röntgenquellen in die Umgebung des Tragsystems ragen und wobei der Innenraum der Tragprofiles (10) mit einer Hochspannungsisolierung (17) ausgefüllt ist.

## Claims

1. X-ray source for ionizing gases with a field emission tip array in a vacuum chamber, wherein the field emission tip array (1) having field emission tips (19) is arranged inside a vacuum region (3b) enclosed by a metallic hood (3) and part of a metallic carrier plate (4), and wherein the field emission tip array (1) is arranged in a manner in which it is electrically insulated with respect to the carrier plate (4) on or above an insulating body (5) in the carrier plate (4) on an electrode (6) extending through the insulating body (5) and is electrically connected to said electrode and is connected, switched as a cathode, to a high-voltage source and wherein an X-ray-transmissive transmission window (2), which consists of beryllium or another suitable material, such as diamond, and is coated with tungsten or another braking material on the vacuum side, is arranged centrally above the field emission tip array (1) in the hood (3), and wherein the hood (3) is switched as an anode.

2. X-ray source according to Claim 1, **characterized in that** the field emission tip array (1) consists of a flat, cuboid basic body, from which a multiplicity of field emission tips (19) protrude.

3. X-ray source according to Claim 2, **characterized in that** the field emission tips (19) are shaped like pointed cones or rods, protrude perpendicularly from a cuboid basic body (18) and are arranged so as to be distributed in a regular array over the face of the basic body (18).

4. X-ray source according to Claim 3, **characterized in that** the field emission tips (19) have rounded ends.

5. X-ray source according to Claim 1 to 4, **characterized in that** the field emission tip array (1) consists of metal or a semiconductor material.

6. X-ray source according to one of the preceding Claims 1 to 5, **characterized in that** the field emission tips (19) of the field emission tip array (1) are surrounded by an insulator (20) such that the region surrounding the tips of the field emission tips (19) is recessed in the form of a crater (23) and **in that** the field emission tips (19) lead into a metallic collar (21) that tapers in the manner of a volcanic cone in the direction of the tip of the field emission tip (19), that concentrically surrounds the field emission tips (19) as a conductive gate and delimits the crater (23).

7. X-ray source according to Claim 6, **characterized in that** the field emission tips (19) protrude from the collar (21).

8. X-ray source according to Claim 6 and 7, **characterized in that** wells (24) are formed between adjacent collars (21), wherein the entire surface of the field emission tip array (1) except for the crater (23) located in the collar (21) is coated with a metal layer (24) .

9. X-ray source according to one of the preceding Claims 1 to 8, **characterized in that** the hood (3) is connected in a vacuum-tight manner to the carrier plate (4) and wherein the carrier plate (4) is connected to ground potential.

10. X-ray source according to one of the preceding Claims 1 to 9, **characterized in that** the field emission tip array (1) inside the vacuum region (3b) is arranged on, and electrically connected to an electrode (6) that extends through the insulating body (5).

11. X-ray source according to one of Claims 1 to 10, **characterized in that** a gate electrode (8) is electrically conductively connected to the metal layer (24) of the field emission tip arrangement (1) via a wire bridge (9), wherein the gate electrode (8) penetrates the insulating body (5) next to the electrode (6).

12. X-ray source according to one of Claims 1 to 11, **characterized in that** the tip radius of the field emission tips (19) is approx. 2 nm.

13. X-ray source according to one of Claims 1 to 12, **characterized in that** the voltage at the gate electrode (8) is 20-100 V.

14. X-ray source according to one of Claims 1 to 13, **characterized in that** the operating voltage of the X-ray source is <5 kV and preferably at the field emission tip array (1), which is switched as a cathode, is preferably between -4980 and -4900 V.

15. Use of the X-ray source according to Claims 1 to 14 in a bar-shaped multi-part carrying system consisting of a bar-shaped hollow carrying profile (10) into which a carrying profile (11) consisting of metal is embedded on a longitudinal side in an insulated fashion and on which a plurality of the X-ray sources are mounted in the longitudinal extend of the carrying profile (11) next to one another with spacings in such a way that the electrodes (6, 8) extend into the carrying profile (10) and are connected to high-voltage feeds (13, 15) extending along the attachment profile (11) and in that the X-ray sources project into the area surrounding the carrying system and wherein the interior of the carrying profile (10) is filled with a high-voltage insulation (17) .

## Revendications

1. Source de rayons X pour l'ionisation de gaz, comprenant un réseau de pointes d'émission de champ dans une chambre à vide, dans laquelle le réseau de pointes d'émission de champ (1) comprenant des pointes d'émission de champ (19) est disposé à l'intérieur d'une zone de vide (3b) qui est entourée par un capot métallique (3) et une partie d'une plaque de support métallique (4), et dans laquelle
le réseau de pointes d'émission de champ (1) est disposé de manière isolée électriquement par rapport à la plaque de support (4) sur ou au-dessus d'un corps isolant (5) dans la plaque de support (4) sur une électrode (6) s'étendant à travers le corps isolant (5), est relié électriquement à celle-ci et est relié à une source à haute tension en étant connecté en tant que cathode, et dans laquelle une fenêtre de transmission (2) transparente aux rayons X est disposée au centre au-dessus du réseau de pointes d'émission de champ (1) dans le capot (3), qui est constitué de béryllium ou d'un autre matériau approprié, tel que le diamant, et est revêtue du côté du vide de tungstène ou d'un autre matériau de freinage et dans laquelle le capot (3) est connecté en tant qu'anode.

2. Source de rayons X selon la revendication 1, **caractérisée en ce que** le réseau de pointes d'émission de champ (1) est constitué d'un corps de base parallélépipédique plat par rapport auquel font saillie une pluralité de pointes d'émission de champ (19).

3. Source de rayons X selon la revendication 2, **caractérisée en ce que** les pointes d'émission de champ (19) sont réalisées en forme de cône pointu ou de tige, font saillie perpendiculairement par rapport à un corps de base parallélépipédique (18) et sont disposées dans un réseau régulier réparti sur la surface du corps de base (18).

4. Source de rayons X selon la revendication 3, **caractérisée en ce que** les pointes d'émission de champ (19) présentent des extrémités arrondies.

5. Source de rayons X selon les revendications 1 à 4, **caractérisée en ce que** le réseau de pointes d'émission de champ (1) est constitué de métal ou d'un matériau semi-conducteur.

6. Source de rayons X selon l'une des revendications 1 à 5 précédentes, **caractérisée en ce que** les pointes d'émission de champ (19) du réseau de pointes d'émission de champ (1) sont entourées par un isolant (20) de telle manière que la zone entourant les sommets des pointes d'émission de champ (19) soit évidée sous la forme d'un cratère (23), et **en ce que** les pointes d'émission de champ (19) aboutissent à un collier métallique (21) qui se rétrécit à la manière d'un volcan en direction du sommet de la pointe d'émission de champ (19), entoure les pointes d'émission de champ (19) de manière concentrique sous forme de grille conductrice et délimite le cratère (23) .

7. Source de rayons X selon la revendication 6, **caractérisée en ce que** les pointes d'émission de champ (19) dépassent du collier (21).

8. Source de rayons X selon les revendications 6 et 7, **caractérisée en ce que** des creux (24) sont ménagés entre les colliers adjacents (21), dans laquelle la totalité de la surface du réseau de pointes d'émission de champ (1), à l'exception du cratère (23) situé dans le collier (21), est revêtue d'une couche métallique (24).

9. Source de rayons X selon l'une des revendications 1 à 8 précédentes, **caractérisée en ce que** le capot (3) est relié de manière étanche au vide à la plaque de support (4) et dans laquelle la plaque de support (4) est reliée au potentiel de la terre.

10. Source de rayons X selon l'une des revendications 1 à 9 précédentes, **caractérisée en ce que** le réseau de pointes d'émission de champ (1) est disposé dans la zone de vide (3b) sur une électrode (6) qui s'étend à travers le corps isolant (5) et qui lui est reliée électriquement.

11. Source de rayons X selon l'une des revendications 1 à 10, **caractérisée en ce qu'**une électrode de grille (8) est reliée de manière électriquement conductrice à la couche métallique (24) de l'agencement de pointes d'émission de champ (1) par l'intermédiaire d'un pont de fils (9), dans laquelle l'électrode de grille (8) pénètre dans le corps isolant (5) au voisinage de l'électrode (6) .

12. Source de rayons X selon l'une des revendications 1 à 11, **caractérisée en ce que** le rayon de pointe des pointes d'émission de champ (19) est d'environ 2 nm.

13. Source de rayons X selon l'une des revendications 1 à 12, **caractérisée en ce que** la tension appliquée à l'électrode de grille (8) est 20 - 100 V.

14. Source de rayons X selon l'une des revendications 1 à 13, **caractérisée en ce que** la tension de fonctionnement de la source de rayons X est de <5 kV et **en ce qu'**elle est de préférence comprise entre -4980 et -4900 V au niveau du réseau de pointes d'émission de champ (1) connecté en tant que cathode.

15. Utilisation de la source de rayons X selon les revendications 1 à 14 dans un système de support en plusieurs parties en forme de barre qui est constitué d'un profilé de support creux en forme de barre (10) dans lequel un profilé de support (11) en métal est encastré de manière isolée sur un côté longitudinal et sur lequel une pluralité de sources de rayons X sont fixées les unes à côté des autres de manière espacée dans l'extension longitudinale du profilé de support (11) de manière à ce que les électrodes (6, 8) s'étendent dans le profilé de support (10) et soient reliées à des alimentations à haute tension (13, 15) s'étendant le long du profilé de fixation (11) et que les sources de rayons X fassent saillie à proximité du système de support et dans laquelle l'espace intérieur du profilé de support (10) est rempli d'une isolation haute tension (17).
